# EUROPÄISCHE PATENTSCHRIFT

(11) **EP 0 942 256 B1**
(45) Veröffentlichungstag und Bekanntmachung des Hinweises auf die Patenterteilung: **12.11.2003**
(21) Anmeldenummer: 99890046.8
(22) Anmeldetag: 09.02.1999
(51) Int. Cl.: F42B 3/195, F42B 3/12, F42B 3/188

(54) **Elektrisch auslösbarer Zünder zum Anschiessen einer Treibladung**
Electric igniter for triggering a propellant charge
Allumeur électrique pour allumer une charge propulsive

(30) Priorität: 09.03.1998 AT 14098
(43) Veröffentlichungstag der Anmeldung: 15.09.1999
(73) Patentinhaber: Hirtenberger Präzisionstechnik GmbH, 2552 Hirtenberg (AT); RICHARD HIRSCHMANN GESELLSCHAFT m.b.H., 6830 Rankweil-Brederis (AT)
(72) Erfinder: Holl, Peter Dipl.-Ing., 89257 Illtertissen-Au (DE); Fabing, Helmut, Ing., 6811 Göfis (AT)
(74) Vertreter: Müllner, Erwin, Dr.

(56) Entgegenhaltungen:
- EP-A- 0 555 651
- EP-A- 0 717 259
- EP-A- 0 863 379
- WO-A-97/21067
- WO-A-98/45663
- CA-A- 1 332 960
- DE-A- 1 763 635
- DE-A- 2 124 854
- FR-A- 1 596 121
- US-A- 2 999 460
- US-A- 3 022 446
- US-A- 3 735 705

## Beschreibung

Die vorliegende Erfindung betrifft einen elektrisch auslösbarer Zünder zum Anschießen einer Treibladung eines Gasgenerators einer Antriebsvorrichtung für Rückhaltesysteme in Kraftfahrzeugen, insbesondere für Sicherheitsgurtstraffer, mit einem Gehäuse, wobei im Zünder integriert, direkt der Zündladung vorgelagert, zumindest ein elektronischer Bauteil vorgesehen ist und wobei der Zünder samt dem zumindest einen elektronischen Bauteil in Kunststoff eingegossen ist.

Ein Zünder dieser Art ist aus dem österreichischen Gebrauchsmuster 522 bekannt. Er dient dazu, im Falle eines Autounfalls den pyrotechnischen Gasgenerator zu zünden, wodurch ein Spannen des Sicherheitsgurtes bewirkt wird. Die elektronischen Bauteile, im einfachsten Fall lediglich eine Induktivität, sind mit den Drähten frei verlötet und in Kunststoff eingegossen. Kunststoff ist mechanisch jedoch nicht sehr stabil. Da er bei der Zündung der Treibladung dem gesamten von der Treibladung entwickelten Druck standhalten muss (bricht er, dann entweichen die entstehenden Gase und gehen für den Antrieb des Rückhaltesystems verloren), wird der Zünder gemäß dem österreichischen Gebrauchsmuster 522 mit einer Kappe 5 aus Stahl abgestützt, wobei die Kappe 5 mit dem Gehäuse 1 zusätzlich noch fest verbunden werden muss. Gemäß der einzigen Figur des Gebrauchsmusters erfolgt diese Befestigung durch Umbiegen (Rollieren) des Gehäuses um eine Stufe der Kappe 5.

Es ist klar, dass durch die Kappe 5 und das Rollieren des Gehäuses Kosten anfallen, die sich in der Massenproduktion, die für derartige Antriebsvorrichtungen notwendig ist, sehr störend bemerkbar machen.

Ein ähnlicher Zünder ist aus EP 555 651 A1 bekannt. Hier ist die Elektronik auf einer Platine angeordnet und vergossen. Die Fixierung im Zünder erfolgt durch einen Dichtungsstöpsel, der durch Rillen im Gehäuse verankert ist.

Es ist Aufgabe der vorliegenden Erfindung, einen Zünder der eingangs genannten Art so weiterzubilden, dass er selbsttragend ist, ohne dass dadurch zusätzlicher Herstellungsaufwand notwendig wäre.

Diese Aufgabe wird durch einen Zünder der eingangs genann-ten Art erfindungsgemäß dadurch gelöst, dass der zumindest eine elektronische Bauteil auf einer Platine oder einem Stanzgitter angebracht ist und zusammen mit dieser Platine bzw. dem Stanzgitter eine Versteifung des Zünders bewirkt, sodaß der Zünder selbsttragend ist und lediglich mit mindestens einem Befestigungselement, vorzugsweise mit zwei Befestigungselementen, wie z.B. Stiften, Splinten, Schrauben u. dgl., im Gehäuse fixiert ist.

Überraschenderweise wurde nämlich festgestellt, dass die elektronischen Bauteile selbst dem Kunststoff eine ausreichende Stabilität verleihen, wenn diese starr auf einer Platine oder auf einem Stanzgitter angeordnet sind. Die für nicht ganz einfache Schaltungen ohnehin selbstverständliche Platine bekommt hier also einen neuen Verwendungszweck: sie bildet zusammen mit den auf ihr angebrachten elektronischen Bauteilen eine Art Armierung des Kunststoffes, sodass dieser nicht mehr durch eine Kappe abgestützt werden muss, sondern der Zünder kann lediglich mit einem Stift oder mit zwei Stiften im Gehäuse fixiert werden. Dadurch ergeben sich entsprechende Einsparungen in der Produktion.

Der Zünder der Antriebsvorrichtung hält dann besonders hohen Gasdrücken stand, wenn die Platine das Befestigungselement bzw. die Befestigungselemente formschlüssig umschließt. Dadurch wird nämlich die Platine direkt (ohne Umweg über den Kunststoff) von den Befestigungselementen in Position gehalten, wodurch die auftretenden Kräfte besonders gut aufgenommen werden können.

Gemäß einer alternativen Ausbildung der Erfindung ist anstelle des zumindest einen elektronischen Bauteils ein Ferritkern vorgesehen, der die Zuleitungsdrähte umgibt und der eine Versteifung des Zünders bewirkt, sodass der Zünder selbsttragend ist und lediglich mit mindestens einem Befestigungselement, vorzugsweise mit zwei Befestigungselementen, wie z.B. Stiften, Splinten, Schrauben u. dgl., im Gehäuse fixiert ist, wobei der Ferritkern das Befestigungselement bzw. die Befestigungselemente formschlüssig umschließt. Ein Ferritkern ist nämlich so groß und massiv, dass er bereits für sich allein (ohne Platine) eine ausreichende Versteifung des Zünders bewirkt.

Die gemeinsame erfinderische Idee ist also, die im Zünder ohnehin vorhandenen Bauteile so auszubilden, dass der Zünder selbsttragend ist, und diesen selbsttragenden Zünder lediglich mit Stiften oder ähnlichen Befestigungselementen im Gehäuse zu fixieren.

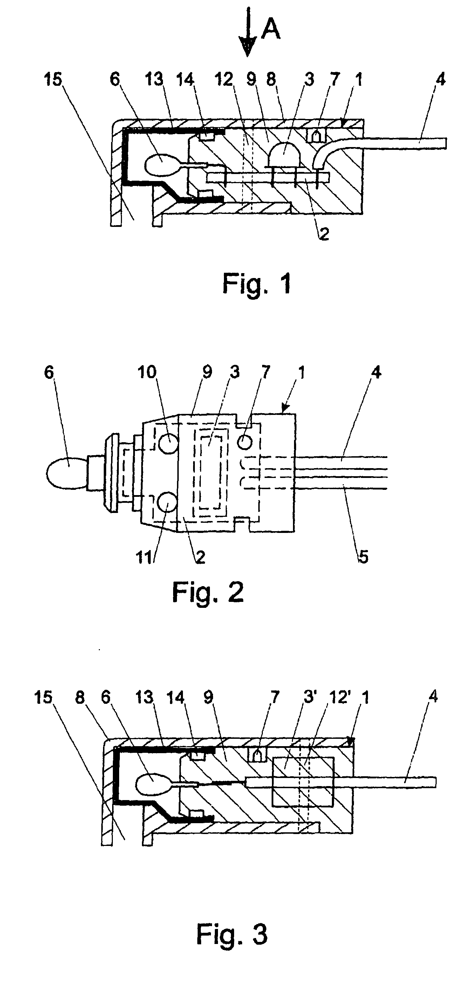

Anhand der beiliegenden Figuren wird die vorliegende Erfindung näher erläutert. Es zeigt: Fig. 1 einen erfindungsgemäßen Zünder, eingebaut in ein Gehäuse, im Schnitt; Fig. 2 denselben Zünder, aber ohne Gehäuse, aus Richtung A in Fig. 1 gesehen; und Fig. 3 zeigt eine andere Ausführungsform eines erfindungsgemäßen Zünders in einer Ansicht analog zu Fig. 1.

Wie man aus den Fig. 1 und 2 ersieht, ist im Zünder 1 eine Platine 2 vorgesehen, die zumindest einen elektronischen Bauteil 3 trägt. Dieser elektronische Bauteil kann eine Induktivität (z.B. eine Stabkerndrossel) sein, die dazu dient, eingestrahlte elektromagnetische Felder bzw. die dadurch entstehenden Spannungen und Ströme sowie leitungsgebundene HF-Wellen soweit abzuschwächen, dass durch diese keine Fehlzündung mehr entstehen kann. Die Erfindung ist aber nicht auf solche elektronische Bauteile beschränkt, die Fehlzündungen infolge Einstreuungen oder statischer Aufladungen verhindern. Es könnte ebenso eine Buselektronik vorgesehen sein, damit der Zünder an ein Datenbussystem angeschlossen werden kann. An der Platine 2 sind auch Zuleitungsdrähte 4, 5 angeordnet, und auch ein Zünderköpfchen 6 ist mit ihr verbunden. Mit der Platine 2 ist weiters eine Elektrode 7 verbunden, die in leitender Verbindung mit einem der Zuleitungsdrähte 4, 5 steht. Sie dient dazu, statische Aufladungen gegen das Gehäuse 8 mit einem Funkenüberschlag abzuleiten.

Die Platine 2 ist samt den elektronischen Bauteilen 3 in Kunststoff 9 eingegossen. Durch die Platine 2 und die elektronischen Bauteile 3 wird der Kunststoff 9 derart gut verstärkt, dass es möglich ist, den Zünder 1 einfach in das Gehäuse 8, das als einseitig offenes Rohr ausgebildet ist, einzuschieben. Zur Fixierung des Zünders 1 im Gehäuse 8 ist es ausreichend, wenn durch die Löcher 10, 11 (s. Fig. 2) Stifte 12 (s. Fig. 1) gesteckt werden, die auch durch entsprechende Öffnungen im Gehäuse 8 durchgehen. Wie man aus der Draufsicht (Fig. 2) erkennt, laufen die Stifte 12 auch durch die Platine 2, sodass diese unmittelbar (und nicht nur über den Kunststoff 9) in ihrer Lage fixiert sind. Die Löcher in der Platine 2 müssen nicht - wie dargestellt - rundum von der Platine begrenzt sein. Auch seitlich offene Nuten erfüllen denselben Zweck. Jede Ausführungsform, bei der eine formschlüssige Verbindung zwischen den Stiften 12 und der Platine 2 besteht, ist möglich.

Es ist gemäß der Erfindung nicht unbedingt notwendig, eine Platine 2 vorzusehen. Alternativ dazu ist es auch möglich, Stanzgitter zu verwenden. (Solch ein Stanzgitter hat letztlich dieselbe Form, wie sie die Kupferbahnen auf der Platine haben. Es wird aber keine dünne Kupferbahn auf einer dicken, stabilen, nicht leitenden Platine verwendet, sondern die gesamte leitfähige Bahn ist derart dick ausgebildet, dass sich die Verwendung einer Platine erübrigt.)

Auf den Zünder 1 ist vorne eine Kappe 13 aufgesteckt, die das Zünderköpfchen 6 umgibt und mit Zündladung gefüllt ist. In die Nut 14 ist eine Dichtung (nicht dargestellt) einzulegen. Das Gehäuse 8 weist vorne eine seitliche Öffnung 15 auf.

Wird der Zünder 1 über die Zuleitungsdrähte 4, 5 gezündet, so explodiert das Zünderköpfchen 6 und somit auch die Zündladung. Die Zündgase entweichen durch die Öffnung 15 und schießen eine Treibladung an. Durch die Detonation der Treibladung wird dann in bekannter Weise ein Kolben mit Druck beaufschlagt, sodass dieser in einem Kolbenrohr verschoben wird und das Gurtschloss zurückzieht. Auf diese Weise wird der Sicherheitsgurt im Falle eines Unfalls gespannt. Dabei wirkt der Gasdruck der Treibladung auch auf die Stirnfläche des Zünders 1. Der Kunststoff 9 muss daher so stabil sein, dass er diesem Gasdruck standhält, auch wenn er an seiner Rückseite nicht unterstützt ist. Erfindungsgemäß wird dies durch die Platine 2 zusammen mit den elektronischen Bauteilen 3 bewirkt.

In Fig. 3 ist an Stelle des elektronischen Bauteils 3 und der Platine 2 ein Ferritkern 3' vorgesehen, der die Zuleitungsdrähte 4,5 umgibt. Die Stifte 12' durchsetzen den Ferritkern in entsprechenden Öffnungen. Der Ferritkern hat aufgrund seiner Größe nahezu dieselbe Wirkung wie eine am Gehäuse 8 fixierte Kappe hinter dem Zünder 1; er hält den Kunststoff 9 sicher in Position.

## Patentansprüche

1. Elektrisch auslösbarer Zünder zum Anschießen einer Treibladung eines Gasgenerators einer Antriebsvorrichtung für Rückhaltesysteme in Kraftfahrzeugen, insbesondere für Sicherheitsgurtstraffer, mit einem Gehäuse, wobei im Zünder integriert, direkt der Zündladung vorgelagert, zumindest ein elektronischer Bauteil vorgesehen ist und wobei der Zünder samt dem zumindest einen elektronischen Bauteil in Kunststoff eingegossen ist, wobei weiters der zumindest eine elektronische Bauteil (3) auf einer Platine (2) oder einem Stanzgitter angebracht ist und zusammen mit dieser Platine (2) bzw. dem Stanzgitter eine Versteifung des Zünders (1) bewirkt, sodaß der Zünder (1) selbsttragend ist und lediglich mit mindestens einem Befestigungselement, vorzugsweise mit zwei Befestigungselementen, wie z.B. Stiften (12), Splinten, Schrauben u. dgl., im Gehäuse (8) fixiert ist.

2. Zünder nach Anspruch 1, **dadurch gekennzeichnet, dass** die Platine (2) das Befestigungselement bzw. die Befestigungselemente formschlüssig umschließt.

3. Elektrisch auslösbarer Zünder zum Anschießen einer Treibladung eines Gasgenerators einer Antriebsvorrichtung für Rückhaltesysteme in Kraftfahrzeugen, insbesondere für Sicherheitsgurtstraffer, mit einem Gehäuse, wobei im Zünder integriert, direkt der Zündladung vorgelagert, zumindest ein Bauteil vorgesehen ist und wobei der Zünder samt dem zumindest einen Bauteil in Kunststoff eingegossen ist, **dadurch gekennzeichnet, dass** der zumindest eine Bauteil ein Ferritkern (3') ist, der die Zuleitungsdrähte (4,5) umgibt und der eine Versteifung des Zünders (1) bewirkt, sodass der Zünder (1) selbsttragend ist und lediglich mit mindestens einem Befestigungselement, vorzugsweise mit zwei Befestigungselementen, wie z.B. Stiften (12), Splinten, Schrauben u. dgl., im Gehäuse (8) fixiert ist, wobei der Ferritkern (3') das Befestigungselement bzw. die Befestigungselemente formschlüssig umschließt.

## Claims

1. Electrically triggerable igniter for firing a propellant charge for a gas generator in a propulsion device for restraining systems in motor vehicles, in particular for safety belt tauteners, having a housing, wherein integrated in the igniter, mounted directly in front of the ignition charge at least one electronic component is provided and wherein the igniter together with the at least one electronic component is embedded in plastic, wherein, furthermore, the at least one electronic component (3) is fitted on a printed circuit board (2) or a pressed screen and together with this printed circuit board (2) or the pressed screen brings about reinforcement of the igniter (1) so that the igniter (1) is self-supporting and is fixed in the housing (8) only by at least one fastening element, preferably by two fastening elements, such as, for example, pins (12), split pins, bolts and the like.

2. Igniter according to Claim 1, **characterised in that** the printed circuit board (2) encloses the fastening element or the fastening elements in form-fitting manner.

3. Electrically triggerable igniter for firing a propellant charge for a gas generator in a propulsion device for restraining systems in motor vehicles, in particular for safety belt tauteners, having a housing, wherein integrated in the igniter, mounted directly in front of the ignition charge at least one component is provided and wherein the igniter together with the at least one component is embedded in plastic, **characterised in that** the at least one component is a ferrite core (3') which surrounds the lead wires (4, 5) and which brings about reinforcement of the igniter (1) so that the igniter (1) is self-supporting and is fixed in the housing (8) only by at least one fastening element, preferably by two fastening elements, such as, for example, pins (12), split pins, bolts and the like, wherein the ferrite core (3') encloses the fastening element or the fastening elements in form-fitting manner.

## Revendications

1. Allumeur déclenchable électriquement pour le branchement à une charge propulsive d'un générateur de gaz d'un système d'entraînement pour des systèmes de retenue dans des véhicules, en particulier pour des rétracteurs de ceintures de sécurité, avec un boîtier, au moins un composant électronique intégré dans l'allumeur étant prévu, juste en amont de la charge d'allumage et l'allumeur y compris le au moins un composant électronique étant scellé dans du plastique, le au moins un composant électronique (3) étant en outre monté sur une platine (2) ou une grille estampée et provoque ensemble avec cette platine (2), respectivement la grille estampée, un raidissement de l'allumeur (1), de telle sorte que l'allumeur (1) est autoportant et est simplement fixé dans le boîtier (8) par au moins un élément de fixation, de préférence par deux éléments de fixation, par exemple des broches (12), des goupilles fendues, des vis ou similaires.

2. Allumeur selon la revendication 1, **caractérisé en ce que** la platine (2) enserre avec imbrication l'élément de fixation, respectivement les éléments de fixation.

3. Allumeur déclenchable électriquement pour le branchement à une charge propulsive d'un générateur de gaz d'un système d'entraînement pour des systèmes de retenue dans des véhicules, en particulier pour des rétracteurs de ceintures de sécurité, avec un boîtier, au moins un composant intégré dans l'allumeur étant prévu, juste en amont de la charge d'allumage et l'allumeur, y compris le au moins un composant, étant scellé dans du plastique, **caractérisé en ce que** le au moins un composant est un noyau de ferrite (3') qui entoure les fils de branchement (4, 5) et qui provoque un raidissement de l'allumeur (1), de telle sorte que l'allumeur (1) est autoportant et est simplement fixé dans le boîtier (8) par au moins un élément de fixation, de préférence par deux éléments de fixation, par exemple des broches (12), des goupilles fendues, des vis ou similaires, le noyau de ferrite (3') enserrant avec imbrication l'élément de fixation, respectivement les éléments de fixation.
